(19) Europäisches Patentamt
European Patent Office
Office européen des brevets

(11)  **EP 3 230 770 B1**

(12)  **FASCICULE DE BREVET EUROPEEN**

(45) Date de publication et mention
de la délivrance du brevet:
**01.09.2021   Bulletin 2021/35**

(51) Int Cl.:
***G01V 1/18*** *(2006.01)*   ***H01L 41/18*** *(2006.01)*

(21) Numéro de dépôt: **15808172.9**

(22) Date de dépôt: **10.12.2015**

(86) Numéro de dépôt international:
**PCT/EP2015/079258**

(87) Numéro de publication internationale:
**WO 2016/092020 (16.06.2016 Gazette 2016/24)**

(54) **HYDROPHONE PIEZOELECTRIQUE A PERFORATIONS, ANTENNE COMPRENANT UNE PLURALITE D'HYDROPHONES ET PROCEDE DE REALISATION DE L'HYDROPHONE**

PERFORIERTES PIEZOELEKTRISCHES HYDROPHON, ANTENNE MIT EINER VIELZAHL VON HYDROPHONEN UND VERFAHREN ZUR HERSTELLUNG DES BESAGTEN HYDROPHONS

PERFORATED PIEZOELECTRIC HYDROPHONE, ANTENNA COMPRISING A PLURALITY OF HYDROPHONES AND METHOD FOR MAKING SAID HYDROPHONE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.12.2014   FR 1402806**

(43) Date de publication de la demande:
**18.10.2017   Bulletin 2017/42**

(73) Titulaire: **THALES**
**92400 Courbevoie (FR)**

(72) Inventeurs:
• **BERNARD, Julien**
**06903 Sophia Antipolis Cedex (FR)**
• **NAKACHE, Maryline**
**06903 Sophia Antipolis Cedex (FR)**
• **DECARLIS, Robert**
**06903 Sophia Antipolis Cedex (FR)**
• **THANNBERGER, Roger**
**06903 Sophia Antipolis Cedex (FR)**
• **CAPLAIN, Antoine**
**06903 Sophia Antipolis Cedex (FR)**
• **BERTRAND, Guy**
**06903 Sophia Antipolis Cedex (FR)**

(74) Mandataire: **Marks & Clerk France**
**Immeuble "Visium"**
**22, avenue Aristide Briand**
**94117 Arcueil Cedex (FR)**

(56) Documents cités:
**US-A- 4 422 003     US-A- 5 334 903**

• **R. GENTILMAN ET AL.: "Sonopanel 1-3 piezocomposite hydrophone-actuator panels", OCEANS'95 MTS/IEEE, 1995, pages 2032-2037, XP002746855,**
• **E.K. AKDOGAN ET AL: "Piezoelectric composites for sensor and actuator applications", IEEE TRANSACTIONS ON ULTRASONICS, FERROELECTRICS AND FREQUENCY CONTROL, vol. 52, no. 5, 1 mai 2005 (2005-05-01), pages 746-775, XP055220526, US ISSN: 0885-3010, DOI: 10.1109/TUFFC.2005.1503962**
• **ROBERTSON D ET AL: "Experimental investigation of alternative pre-stress components for a 3-1 connectivity multilayer piezoelectric-polymer composite ultrasonic transducer", ULTRASONICS, IPC SCIENCE AND TECHNOLOGY PRESS LTD. GUILDFORD, GB, vol. 40, no. 1-8, 1 mai 2002 (2002-05-01), pages 913-919, XP004357319, ISSN: 0041-624X, DOI: 10.1016/S0041-624X(02)00225-1**
• **None**

**Description**

**ART ANTERIEUR**

L'invention se situe dans le domaine des antennes de réception des sonars, notamment des sonars passifs, destinés à être utilisées dans le milieu sous-marin. Les antennes de détection sonars comprennent une pluralité d'hydrophones. Les hydrophones sont destinés à mesurer une pression acoustique, par exemple pour détecter des objets sous-marins. Les hydrophones sont classiquement montés sur une structure porteuse comme par exemple la coque d'un sous-marin ou d'un bâtiment de surface ou une flute destinée à être tractée par un navire. Typiquement, un hydrophone est de dimensions très petites devant la longueur d'onde acoustique. La pression acoustique peut alors être considérée comme une pression hydrostatique, c'est à dire d'amplitude et de phase identique sur toutes les faces de l'hydrophone. Des matériaux piézoélectriques sont utilisés pour assurer la conversion de la pression acoustique en signal électrique. Ils ont généralement une mauvaise sensibilité en mode hydrostatique, c'est à dire lorsque les contraintes normales sont identiques dans les trois directions. La plupart des conceptions d'hydrophone est donc basée sur l'amplification ou la réduction de la contrainte dans une ou plusieurs directions afin de faire travailler le matériau dans un mode plus favorable. Parmi les capteurs élémentaires actuels, on trouve des capteurs multicouches à électrodes dites rigides. Ces capteurs comprennent un empilement d'un nombre variable de couches de matériau piézoélectrique, généralement du PVDF (polyfluorure de vinylidène) polarisé sous contrainte, et d'électrodes en métal rigide réalisées par exemple en Al, Cu-Be, ou Cu-Sn. Par électrode rigide, on entend une électrode présentant une raideur dans le plan de la couche d'électrode supérieure à la raideur de la couche du matériau piézoélectrique dans le plan de la couche piézoélectrique. Ces électrodes rigides ont pour fonction de limiter la déformation latérale du PVDF, ce qui a deux conséquences. L'une bénéfique, est de réduire fortement la contrainte latérale dans le PVDF due à la pression appliquée dans la direction latérale. L'autre néfaste, est de générer par effet de Poisson une contrainte latérale due à la pression appliquée dans la direction verticale. En pratique, la contrainte latérale dans le PVDF est ainsi réduite d'environ 20 % par rapport à la pression extérieure, la contrainte verticale restant inchangée. Le matériau PVDF fonctionne alors en mode d'épaisseur (aussi appelé mode bloqué). La sensibilité est améliorée de 2 à 4 dB par rapport au mode hydrostatique. Les couches de PVDF sont réalisées dans un matériau piézoélectrique homogène, c'est-à-dire, ne comprennent que du PVDF, par opposition à un matériau piézoélectrique composite comprenant un matériau piézoélectrique et au moins un autre matériau. Dans la suite du texte, on désignera ce type de capteur par 'capteur multicouche à plaques élastiques rigides et plaques piézoélectriques homogènes'. Ce type de capteur présente une bonne sensibilité, un haut niveau de saturation et une faible dispersion de fabrication, une compensation en accélération simple à réaliser par la connexion en série ou parallèle de couches de polarisation opposée, une capacité à réaliser de grandes surfaces acoustiques continues, une épaisseur très faible, une très grande robustesse mécanique et tenue à l'immersion, du fait de l'absence d'amplification mécanique, un coût de main d'œuvre faible dû au faible nombre de pièces et d'opérations, une faible sensibilité accélérométrique comparée à la sensibilité hydrophonique.

Ce type d'hydrophone présente l'avantage de ne pas avoir un mode de résonance à fort coefficient de couplage électromécanique dans ou à proximité de sa bande utile de fonctionnement ce qui évite les problèmes de dispersion de la sensibilité hydrophonique Sh du capteur et de risque de saturation face à un brouilleur si la surtension induite par la résonnance est trop importante. Dans le capteur, des modes de flexion existent dans la bande utile mais ils présentent un couplage mécanique très faible du fait du montage en bicouche, c'est-à-dire dans lequel la couche piézoélectrique est prise en sandwich entre deux électrodes. Par ailleurs, le transducteur présente une excellente tenue à la pression hydrostatique, en effet, le chargement étant hydrostatique (sensiblement égal dans les trois directions), la contrainte de Von Mises dans les matériaux reste faible. Cette absence de modes de résonance à fort coefficient de couplage dans ou à proximité de la bande de fréquence de fonctionnement du dispositif permet de réaliser des capteurs selon l'invention de grandes dimensions sans avoir nécessairement à recourir à des groupements de plusieurs capteurs élémentaires, généralement 4 de façon à obtenir l'effet de filtrage surfacique requis ou pour obtenir une bonne compensation en accélération. Cela permet de ne pas avoir d'augmentation de coûts du capteur dus à des opérations supplémentaires de câblage et à l'ajout de pièces supplémentaires de positionnement relatif des capteurs élémentaires.

La tendance actuelle est à l'augmentation des fréquences des ondes acoustiques émises par les objets recherchés par les sonars passifs. Or, les différentes formes de bruit propre (bruit rayonné par le support ou la structure porteuse des hydrophones, bruit d'écoulement direct de l'eau sur l'hydrophone) diminuent rapidement avec la fréquence, le niveau de bruit en sortie de formation de voie devient limité par le bruit électrique du canal hydrophonique ce qui impose de réaliser des transducteurs électroacoustiques présentant un bruit électrique le plus faible possible. Par ailleurs, l'utilisation de plus en plus fréquente de dispositifs d'isolation de l'antenne vis-à-vis du bruit mécanique (comme des dispositifs de bafflage acoustique), ou d'algorithmes de traitements adaptatifs ont également pour effet de réduire davantage le niveau de bruit mécanique en sortie de formation de voie. En outre, la diminution du bruit propre est encore plus importante lorsque la structure porteuse est revêtue d'un matériau de masquage et/ou anéchoïque visant à améliorer la discrétion acoustique de la structure porteuse (bruit rayonné par la structure porteuse) et la furtivité (émission d'échos de cible vis-à-vis de sonars actifs). En effet, ce type de revêtement diminue encore plus le niveau du bruit mécanique en sortie de formation de voie, principal contributeur du bruit propre lorsque l'hydrophone est fixe ou se déplace à faible vitesse. La suppression du gain de réponse signal due à la réflexion sur le support a pour effet de contraindre encore davantage l'exigence de réduction du bruit électrique exprimée en niveau de bruit isotrope équivalent.

En effet le bruit électrique en niveau de bruit isotrope équivalent d'un hydrophone est donné par

$$N_{FV}^{A} = \frac{N_{FV} HG^{A}}{S_{FV}},$$

où $N_{FV}$ est le niveau de bruit électrique en sortie de formation de voie, $HG^{A}$ est le gain de l'hydrophone en bruit ambiant isotrope, i.e. le facteur de directivité (DF), et $S_{FV}$ est le niveau de la réponse en signal de l'antenne. A niveau de bruit électrique (en $V^2/Hz$) identique, la réduction du niveau de la réponse signal $S_{FV}$ se traduit par une augmentation du niveau de bruit électrique $N_{FV}$ exprimé en bruit isotrope équivalent (en $Pa^2/Hz$), le facteur de directivité étant peu affecté par le revêtement du support.

Il est donc fondamental de proposer un hydrophone satisfaisant aux exigences plus strictes de bruit électrique du canal hydrophonique. Autrement dit, il est fondamental de proposer un hydrophone présentant un bruit électrique faible pour pouvoir travailler à des fréquences supérieures. Le bruit électrique du canal hydrophonique est en grande partie déterminé par le bruit électrique de l'hydrophone (en bruit isotrope équivalent) donné par l'inverse de $Sh^2Ch/tan(\delta)$, où $Sh$ est la sensibilité hydrophonique exprimée en $V/\mu Pa$, $Ch$ la capacité exprimée en Farads, $tan(\delta)$ les pertes diélectriques. Or, le problème majeur du capteur élémentaire multicouche à plaques piézoélectriques homogènes réside dans l'augmentation importante des pertes diélectriques du matériau PVDF avec la fréquence ce qui a pour conséquence d'augmenter le bruit électrique du capteur élémentaire.

Pour obtenir un niveau de bruit électrique acceptable, l'approche usuelle consiste à maximiser le volume de matériau actif. Cela peut être obtenu soit en maximisant la surface du capteur (augmentation de la capacité Ch), soit en augmentant son épaisseur par l'ajout de couches supplémentaires de PVDF (augmentation de Sh). Or, cette solution ne permet pas de répondre à l'exigence de couverture angulaire de l'antenne aux plus hautes fréquences, puisque cette exigence implique une réduction de la surface du capteur élémentaire. Par ailleurs, elle ne permet pas de respecter une contrainte d'intégration du capteur dans un volume d'épaisseur donnée qui n'autorise pas à augmenter indéfiniment l'épaisseur du matériau PVDF afin d'améliorer la sensibilité ou la capacité du capteur élémentaire. Cette contrainte en termes de volume est notamment due à des raisons de bande passante de la sensibilité hydrophonique sur la structure porteuse.

Pour améliorer le bruit électrique du capteur multicouche sans augmenter le volume de matériau piézoélectrique, une autre approche consiste à utiliser des matériaux à meilleure figure de mérite (produit $Sh^2Ch/tan(\delta)$ par unité de volume). Ces matériaux sont en majorité des composites piézoélectriques, ou piézocomposites, pour lesquels existe une classification spécifique. La classification des composites piézoélectriques est basée sur la topologie des phases et non leur géométrie. Par exemple un piézocomposite m-n, m $\in$ {0,1,2,3}, n$\in$ {0,1,2,3} désigne un composite diphasique dont la phase 1 est connectée selon m directions et la phase 2 selon n directions. La connectivité détermine uniquement le nombre de directions selon lesquelles les différents domaines d'une même phase sont connectés. Les phases peuvent être de forme et de dimensions arbitraires. Typiquement, seule une phase est piézoélectrique, l'autre est un matériau solide ou fluide non piézoélectrique type polymère ou air. La phase 1 est généralement utilisée pour désigner le matériau piézoélectrique, la phase 2 le matériau non piézoélectrique. Pour un piézocomposite de connectivité donnée, plusieurs configurations sont possibles selon les directions de connectivité par rapport à la direction de polarisation du matériau piézo.

Un premier groupe de matériaux plus performants est constitué par des polymères piézoélectriques, comme par exemple le copolymère P(VDF-TrFE) ou le PVDF poreux. Le copolymère P(VDF-TrFE), est un polymère piézoélectrique monophasique dont les sensibilités en mode hydrostatique et en mode bloqué sont environ 50% supérieures à celles du PVDF, au détriment de la permittivité qui est environ 30% inférieure. Le PVDF poreux est un composite piézoélectrique constitué d'une matrice de PVDF et d'inclusions d'air microscopiques et totalement encapsulées. Le PVDF poreux est donc un piézocomposite de connectivité 3-0. L'adjonction de microfissures dans le PVDF permet de doubler la sensibilité du matériau en mode hydrostatique, au détriment de la permittivité, environ 20% inférieure. En revanche aucune amélioration supplémentaire n'est observée en mode bloqué, principalement à cause du coefficient de Poisson élevé. Ces matériaux permettent de diminuer le bruit électrique du capteur de quelques décibels pour un volume donné, cependant avec une augmentation conséquente du coût d'approvisionnement. Par ailleurs la tenue en pression statique du PVDF poreux est limitée et une dégradation irréversible des propriétés se produit au-delà de 70 bars.

Un second groupe de matériaux plus performants est constitué par les matériaux composites 1-3, comme notamment décrit dans le document R. GENTILMAN ET AL.: "Sonopanel 1-3 piezocomposite hydrophone actuator panels", OCEANS'95 MTS/IEEE, 1995, pages 2032-2037. Des colonnes de matériau piézoélectrique sont disposées parallèlement les unes des autres suivant une direction de polarisation perpendiculaire au plan de la couche, et espacées les unes des autres. Les colonnes sont noyées dans une matrice de matériau polymère de raideur faible devant celle du matériau piézoélectrique. Les raideurs mécaniques effectives du composite dans les directions verticale et latérale sont fortement réduites par rapport au matériau piézoélectrique initial. En présence d'électrodes rigides, cela a pour effet d'amplifier la contrainte verticale dans les colonnes piézoélectriques, d'améliorer l'effet de blocage latéral des électrodes, et de diminuer le coefficient de Poisson effectif. Malheureusement, dans ce type de composite, le matériau de remplissage est exposé à la pression statique sur les faces latérales de la plaque. Le choix du matériau de remplissage résulte donc d'un compromis entre performance et tenue en immersion, ie entre raideur faible et limite élastique élevée. Des polymères relativement rigides et résistants sont donc typiquement utilisés, ce qui limite le gain de sensibilité potentiel, et restreint le champ d'application aux matériaux piézoélectriques rigides, (céramiques ou monocristaux piézoélectriques). Les composites 1-3 permettent d'abaisser fortement le bruit électrique du capteur mais fournissent une sensibilité médiocre à épaisseur donnée, ce qui a tendance à pénaliser le bruit électrique du canal complet (alors largement dominé par le bruit de la chaîne de préamplification). Pour compenser ce phénomène, une partie de la surface du capteur doit être échangée en épaisseur afin d'améliorer la sensibilité, au détriment de l'intégrabilité du capteur. Des composites piézoélectriques de connectivité 2-2, 3-1 ou 3-2 peuvent également être utilisés. Cependant les configurations explorées jusqu'ici souffrent des mêmes limitations, dues au fait que le matériau de remplissage est toujours débouchant sur l'extérieur et soumis à la pression statique.

## RESUME DE L'INVENTION

Le but de l'invention est de pallier tout ou partie des inconvénients précités.

A cet effet, l'invention a pour objet un hydrophone configuré pour fonctionner en mode traction compression comprenant un empilement de couches collées entre elles, l'empilement étant réalisé selon une direction d'empilement, les couches comprenant au moins une couche piézoélectrique et une pluralité de couches dites rigides dont au moins deux sont des couches d'électrodes, les couches rigides présentant une raideur perpendiculairement à la direction d'empilement, supérieure à la raideur de la couche piézoélectrique perpendiculairement à la direction d'empilement. Dans l'hydrophone selon l'invention, au moins une couche piézoélectrique comprend une zone centrale comprenant un ensemble de perforations traversant la couche piézoélectrique selon la direction d'empilement. Chaque perforation est fermée de façon étanche par des éléments de fermeture comprenant des portions de deux des dites couches rigides, les dites deux couches rigides s'étendant sur la totalité de la surface de la zone centrale.

La solution apportée consiste à améliorer l'hydrophone multicouche à plaques piézoélectriques homogènes par une modification de sa conception. Plus spécifiquement elle repose sur la réalisation de perforations dans les couches de matériau piézoélectrique. Ces perforations sont remplies d'un matériau de remplissage qui peut être un matériau solide ou un fluide, comme par exemple un gaz ou même du vide. Le matériau piézoélectrique de la couche, connecté selon les trois directions, et le matériau de remplissage, connecté uniquement dans la direction d'empilement, forment un piézocomposite de connectivité 3-1. Les perforations ont pour fonction de réaliser un découplage latéral dans la direction perpendiculaire aux perforations, permettant ainsi de faire travailler le matériau piézoélectrique dans un mode plus favorable que dans un capteur multicouche à plaques homogènes et d'améliorer la sensibilité du capteur. Par ailleurs, les perforations permettent d'obtenir un effet d'amplification de contrainte dans la direction d'empilement par le rapport des surfaces des couches rigides et des couches de matériau piézoélectrique, qui s'ajoute à l'effet précédent et permet encore d'améliorer la sensibilité du capteur.

Le capteur selon l'invention conserve les mêmes principaux avantages du capteur multicouche à plaques homogènes à savoir une réponse plate dans la bande de fréquence de fonctionnement, une faible sensibilité accélérométrique comparée à sa sensibilité hydrophonique, un bon filtrage surfacique permettant de filtrer un bruit caractérisé par des longueurs d'onde très courtes sur la surface du capteur, un haut niveau de saturation caractérisé par le niveau sonore acceptable par le canal hydrophonique, une faible dispersion de fabrication, une compensation en accélération due à l'insensibilité à un champ de pression antisymétrique, une simplicité de réalisation par la connexion en série ou parallèle de couches de polarisation opposée, une capacité à réaliser de grandes surfaces acoustiques continues, une épaisseur très faible.

La modification de conception proposée conduit, toutes choses égales par ailleurs, à une augmentation significative de la sensibilité Sh, une légère réduction de la capacité Ch, et une nette augmentation du facteur de mérite $Sh^2Ch/tan(\delta)$, plus ou moins élevées selon le type de symétrie et le coefficient de Poisson du matériau piézoélectrique utilisé. Par conséquent, l'invention conduit à une réduction du bruit électrique du transducteur électroacoustique. Cette diminution du bruit électrique est obtenue avec une augmentation minime du coût du capteur due uniquement à la réalisation des perforations et sans augmentation du volume de matériau piézoélectrique notamment de l'épaisseur de matériau piézoélectrique. Par conséquent, l'hydrophone selon l'invention présente de meilleures performances aux fréquences élevées.

Le fait que, dans la solution proposée, on utilise des plaques piézoélectriques de connectivité 3-1, est très avantageux. En effet, lorsque l'on utilise une plaque de matériau piézoélectrique composite de type 1-3 ou 2-2 monolithique, dans laquelle les interstices entre les bâtonnets ou les barreaux homogènes sont remplis d'un matériau de remplissage polymère, le gain de sensibilité du capteur élémentaire est minoré, principalement à cause de la raideur non négligeable du matériau polymère devant celle du matériau piézoélectrique. Le choix du matériau piézoélectrique du composite 1-3 ou 2-2 est restreint aux céramiques piézoélectriques, présentant une raideur suffisante par rapport à celle des matériaux de remplissage usuels, et exclut les polymères piézoélectriques. Dans le cas de plaques composites de connectivité 3-1, le matériau de remplissage est entièrement encapsulé, par les électrodes rigides dans la direction verticale, et par le matériau piézoélectrique dans les directions latérales, et subit des contraintes réduites par rapport à la pression ambiante. Cela autorise le remplissage des perforations par un matériau extrêmement souple, tel qu'une mousse à cellules ouvertes, un gaz voire même du vide. De façon générale, lorsqu'un solide est utilisé comme matériau de remplissage, on obtient de bons résultats lorsque le module d'Young du matériau de remplissage est inférieur au quart du module d'Young du matériau piézoélectrique défini perpendiculairement au plan de la couche. Lorsqu'un fluide est utilisé comme matériau de remplissage, son module de compressibilité isotrope est avantageusement inférieur au quart du module de compressibilité isotrope du matériau piézoélectrique. Une mousse à cellules ouvertes ou simplement de l'air présentent une raideur extrêmement faible et offrent un découplage maximal proche du vide. Le gain de sensibilité est ainsi maximisé. Le choix du matériau piézoélectrique dans le composite 3-1 peut être étendu aux polymères piézoélectriques tels que le PVDF. Dans la suite l'hydrophone selon l'invention pourra être désigné hydrophone multicouche à plaques piézoélectriques perforées ou plaques piézoélectriques composite 3-1.

La capacité de l'hydrophone est également réduite par rapport à un capteur monolithique multicouche. Par conséquent l'invention est particulièrement adaptée aux matériaux de faible sensibilité, forte permittivité, tels que les composites 1-3. La matrice piézoélectrique du composite 3-1 est alors constituée de composite 1-3.

L'hydrophone à plaques piézoélectriques perforées conserve la plupart des avantages de l'hydrophone à plaques homogènes : absence de mode de résonance dans la bande, faible dispersion de fabrication, faible sensibilité accélérométrique, surface acoustique continue et potentiellement de grandes dimensions. La tenue en pression statique est réduite du fait de l'amplification de contrainte se produisant dans le matériau piézoélectrique. Elle reste cependant largement suffisante pour les besoins opérationnels.

Avantageusement, au moins une couche piézoélectrique comprend au moins une plaque monobloc de matériau piézoélectrique comprenant une zone centrale comprenant une pluralité de perforations, ladite zone centrale intégrant lesdites perforations dans le plan de la couche et intégrant au moins partiellement lesdites perforations selon la direction d'empilement. La couche piézoélectrique comprend une unique plaque monobloc intégrant les perforations. En variante, la couche comprend une pluralité de plaques monoblocs telles que définies précédemment empilées selon la direction d'empilement de façon que les perforations des plaques soient superposées selon la direction d'empilement de façon à former les perforations de la couche piézoélectrique.

Cette solution présente une différence de coût très faible avec le capteur multicouche à plaques homogènes puisque la seule différence de coût réside dans la réalisation de perforations dans la couche piézoélectrique.

Par ailleurs, elle permet de conserver le procédé de fabrication simple et peu coûteux du capteur monolithique consistant à réaliser un simple empilement de la plaque de matériau piézoélectrique monobloc et des électrodes.

Les perforations sont séparées par des barreaux solidaires les uns des autres. Cette solution évite ainsi des problèmes de positionnement relatif des perforations et notamment le recours à un outillage complexe qui serait nécessaire pour positionner des barreaux indépendants. Cette solution permet d'éviter d'avoir à venir rapporter des éléments supplémentaire aux extrémités des perforations pour assurer leur fermeture étanche et la tenue en pression du dispositif ce qui impliquerait une complexité et un temps de fabrication accrus du capteur.

Avantageusement, la couche comprenant la zone centrale comprend un cadre piézoélectrique monolithique entourant complètement la zone centrale, le cadre monolithique étant réalisé en matériau piézoélectrique.

L'hydrophone selon l'invention se distingue d'un hydrophone multicouche qui utiliserait des plaques de PVDF poreux par

■ la topologie des inclusions de matériau de remplissage :

    o de connectivité 0 (emprisonnées dans le volume) dans le PVDF poreux (composite 3-0)
    o de connectivité 1 (débouchant dans la direction 3) dans le PVDF perforé (composite 3-1)

■ l'échelle des inclusions de matériau de remplissage :

    o microscopiques (< 0,1 mm) dans le PVDF poreux,
    o macroscopiques ($\geq$ 0,1 mm) dans le PVDF perforé

■ possibilité d'ajustement de la fraction volumique de matériau de remplissage plus importante avec le PVDF perforé, permettant un ajustement du compromis sensibilité/capacité.

Le PVDF poreux ayant un coefficient de Poisson élevé, il présente un potentiel d'amélioration important par perforation (différence importante entre g3t et g33). Ce potentiel est toutefois limité par la tenue en pression plus faible de ce matériau.

L'hydrophone selon l'invention se distingue du piezo-composite 3-1 :

■ directions relatives de connectivité des inclusions et de polarisation

    o perpendiculaires pour le piezo-composite 3-1,
    o parallèles pour la solution proposée selon l'invention,

■ plaques rigides

    o non partie dans le piezo-composite 3-1, ce qui implique le remplissage des perforations par un matériau solide type polymère,
    o partie intégrante de la solution proposée selon l'invention, et permettant le remplissage par tout matériau et en particulier par de l'air.

Avantageusement, au moins une couche piézoélectrique comprend une unique plaque monobloc de matériau piézoélectrique.

Avantageusement, au moins une couche piézoélectrique comprend un empilement élémentaire réalisé selon la direction d'empilement d'une pluralité de plaques monoblocs de matériau piézoélectrique, chaque plaque monobloc comprenant une zone centrale comprenant une pluralité de perforations, les plaques étant empilées de façon que les perforations desdites plaques soient superposées dans la direction d'empilement.

Avantageusement, chaque couche rigide s'étend sur la totalité de la surface de chaque couche piézoélectrique qui est contigüe à ladite couche rigide dans l'empilement.

Avantageusement, au moins une couche piézoélectrique comprenant une zone centrale comprenant un ensemble de perforations est réalisée dans un matériau piézoélectrique simple orthotrope étiré selon la direction longitudinale, tel que le PVDF.

Avantageusement, au moins une couche piézoélectrique comprenant une zone centrale comprenant un ensemble de perforations est réalisée dans un matériau possédant un module d'Young supérieur ou égal à 10 GPa et un coefficient de poisson supérieur ou égal à 0,35 et est notamment réalisée en PZT, co-polymère ou PVDF.

Avantageusement, au moins une couche piézoélectrique comprenant une zone centrale (20) comprenant un ensemble de perforations est réalisée à partir d'un matériau piézo-composite de type 1-3.

Avantageusement, les perforations sont séparés deux à deux par des barreaux de matériau piézoélectrique et dans lequel au moins une couche piézoélectrique comprenant une zone centrale comprenant un ensemble de perforations est dimensionnée de façon qu'un rapport de forme des barreaux défini par le rapport entre l'épaisseur de la couche piézoélectrique et la largeur des barreaux compris dans la zone centrale selon une direction perpendiculaire aux directions longitudinale et d'empilement de ladite couche est au moins égal à 0,25.

Avantageusement, la couche piézoélectrique est formée dans un matériau présentant une isotropie transverse perpendiculairement à la direction d'empilement et les perforations s'étendent de la même façon dans deux directions perpendiculaires à la direction d'empilement.

Alternativement, la couche piézoélectrique peut être formée dans un matériau présentant une anisotropie transverse perpendiculairement à la direction d'empilement et dans lequel les perforations s'étendent principalement dans une direction perpendiculaire à la direction d'empilement.

Avantageusement, les perforations sont disposées de façon régulière dans deux directions perpendiculaires à la direction d'empilement.

L'invention a également pour objet une antenne de réception comprenant une pluralité d'hydrophones selon l'invention.

L'invention a encore pour objet un procédé de réalisation d'un hydrophone selon l'invention, dans lequel les perforations sont réalisées par découpe d'un matériau piézoélectrique monobloc.

Avantageusement, le matériau piézoélectrique est polarisé avant réalisation des perforations par découpe.

## PRESENTATION DES FIGURES

D'autres caractéristiques et avantages de l'invention apparaîtront à la lecture de la description détaillée qui suit, faite à titre d'exemple non limitatif et en référence aux dessins annexés dans lesquels :

-     la figure 1 représente schématiquement en perspective un premier exemple d'hydrophone selon l'invention,
-     la figure 2 représente schématiquement en coupe un deuxième exemple d'hydrophone selon l'invention,
-     la figure 3 représente schématiquement en perspective une couche piézoélectrique de connectivité 3-1 de l'hydrophone représenté sur la figure 1,
-     la figure 4 représente schématiquement en vue de dessus la couche piézoélectrique de connectivité 3-1 de la figure 3,
-     la figure 5 représente une coupe de l'hydrophone de la figure 1 selon le plan M, dans le cas de perforations de rapport de forme longueur/largeur élevé

- la figure 6 représente en perspective éclatée l'hydrophone de la figure 1, dans le cas de perforations de rapport de forme longueur/largeur élevé
- les figures 7a à 7d représentent des variantes de la couche piézoélectrique, dans le cas de perforations de rapport de forme longueur/largeur faible

D'une figure à l'autre, les mêmes éléments sont repérés par les mêmes références.

## DESCRIPTION DETAILLEE DE PLUSIEURS MODES DE REALISATION DE L'INVENTION

L'invention se rapporte à un hydrophone configuré pour fonctionner en mode traction compression. Ce type d'hydrophone est agencé de façon à être soumis à la même pression sur toutes leurs faces. Il est donc configuré pour présenter un domaine de fréquences de fonctionnement dans lequel il présente une taille très inférieure à la longueur d'onde des ondes acoustiques détectées.

Ce type d'hydrophones s'oppose aux hydrophones destinés à fonctionner en flexion, comme les hydrophones du type dit à poutres cantilever destinés à détecter des différences de pression entre leurs faces opposées.

L'hydrophone selon l'invention peut être destiné à être immergés à grande profondeur. Dans ce cas, il doit résister à des pressions hydrostatiques élevées par exemple d'au moins 30 bars (1 bar = $10^5$ Pa).

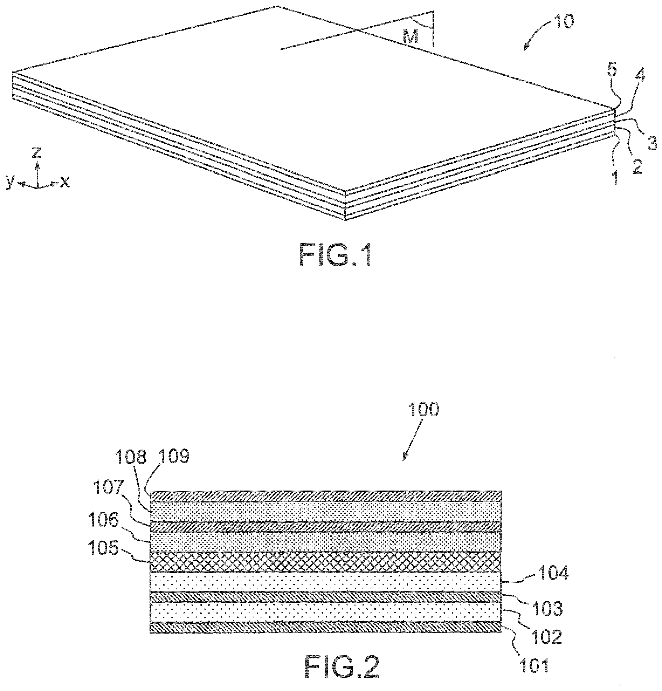

Sur la figure 1, on a représenté schématiquement en perspective un exemple d'hydrophone selon l'invention. Cet hydrophone comprend un empilement 10 de couches 1 à 5 par exemple assemblées par collage. D'autres moyens d'assemblage sont possibles comme notamment par polymérisation d'un des matériaux constituant l'hydrophone. L'empilement 10 est réalisé selon une direction d'empilement z. De plus, on définit, des directions x et y perpendiculaires entre elles et à la direction d'empilement z. Les couches s'étendent dans des plans contenant les directions x, y et comprennent trois couches dites rigides 1, 3, 5 et deux couches de matériau piézoélectrique 2, 4. Les couches rigides 1, 3, 5 peuvent être des électrodes. Dans ce cas ce sont des couches électriquement conductrices, par exemple métalliques, connectées électriquement en parallèle ou en série par des connexions électriques qui ne sont pas représentées sur la figure 1. Chaque couche piézoélectrique 2, 4 est interposée, c'est-à- dire prise en sandwich, entre les deux couches rigides 1 et 3 d'une part et 3 et 5 d'autre part. Chaque couche piézoélectrique est collée aux deux couches rigides qui l'entourent. Une couche rigide peut ne pas être conductrice et avoir uniquement une fonction mécanique de rigidification latérale.

De manière générale, l'empilement 10 comprend une pluralité de couches rigides dont au moins deux sont des couches d'électrodes. Dans l'empilement représenté, sont empilées en alternance, une couche piézoélectrique et une couche rigide. On peut également réaliser un empilement avec des couches successives de même type. L'empilement comprend au moins une couche piézoélectrique et deux couches rigides. Sur la réalisation de la figure 2, on a représenté en vue en coupe dans un plan contenant la direction z d'empilement un deuxième exemple d'empilement 100 comprenant une pluralité de couches de matériau piézoélectrique 102, 104, 106, 108 et une pluralité de couches rigides 101, 103, 105, 107, 109 qui sont toutes des électrodes connectées électriquement entre-elles en série et/ou en parallèle. Les couches de matériau piézoélectrique ne sont pas toutes réalisées dans le même matériau piézoélectrique. Les couches rigides ne sont pas toutes réalisées dans le même matériau. Les couches ne présentent pas toutes la même épaisseur. En variante, toutes les couches de matériau piézoélectrique sont réalisées dans le même matériau et/ou présentent la même épaisseur et/ou toutes les couches rigides sont réalisées dans le même matériau et/ou présentent la même épaisseur.

Par couches rigides on entend des couches présentant des raideurs supérieures à la raideur de la (ou des) couche(s) de matériau piézoélectrique adjacentes perpendiculairement à la direction d'empilement. La raideur d'une couche d'un matériau est ici définie comme le produit de son module d'Young et de son épaisseur. Une des fonctions de ces couches rigides est de limiter la déformation latérale du matériau piézoélectrique, ce qui permet de réduire les contraintes latérales, c'est-à-dire perpendiculaires à la direction z, et donc de garantir une bonne constante diélectrique effective de l'hydrophone. Cet effet est déjà présent dans le capteur à plaques homogènes. Dans le capteur à plaques perforées selon l'invention, l'effet est présent dans la zone périphérique homogène, et dans la zone centrale perforée dans les directions où il n'y a pas de découplage latéral. L'effet est d'autant plus important que couches rigides sont raides par rapport au matériau piézoélectrique. Dans les couches rigides, on observe des contraintes latérales de traction et de compression dues de la flexion. Une autre fonction des couches rigides est de minimiser la déformation en flexion au droit des perforations afin d'homogénéiser la déformation selon la direction d'empilement z du matériau piézoélectrique et du matériau de remplissage et ainsi assurer une amplification de la contrainte en traction selon la direction z dans le matériau piézoélectrique. Des essais en interne ont montré un bon fonctionnement de l'hydrophone pour un rapport entre la raideur d'une couche rigide et la raideur d'une couche piézoélectrique adjacente supérieur ou égal à 2,5. Des électrodes en Al, Cu-Be ou Cu-Sn avec une épaisseur totale d'environ 75% de l'épaisseur totale des couches de matériau piézoélectrique remplissent cette condition dans le cas où le matériau piézoélectrique est un polymère ou un composite piézoélectrique.

Les couches rigides comprennent au moins deux électrodes et peuvent comprendre d'autres couches rigides dont la seule fonction est de limiter la déformation latérale des couches de matériau piézoélectrique. Ces couches présentent donc les conditions de raideur requises et définies au paragraphe précédent mais ne sont pas reliées électriquement entre elles ou aux électrodes.

Les couches d'électrodes sont des couches conductrices, par exemple, des couches métalliques réalisées par exemple en Aluminium, en alliage CuBe, ou en alliage CuSn. Les autres couches rigides ne sont pas nécessairement conductrices.

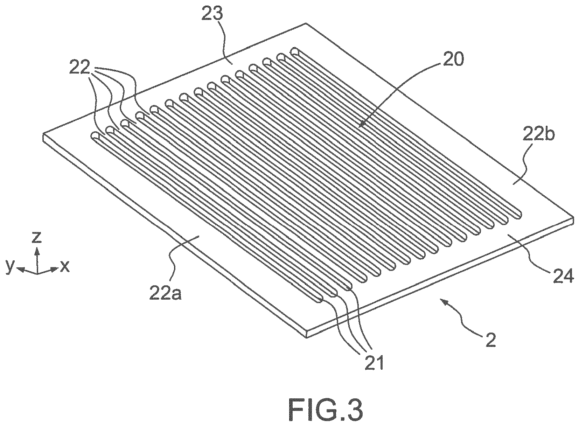

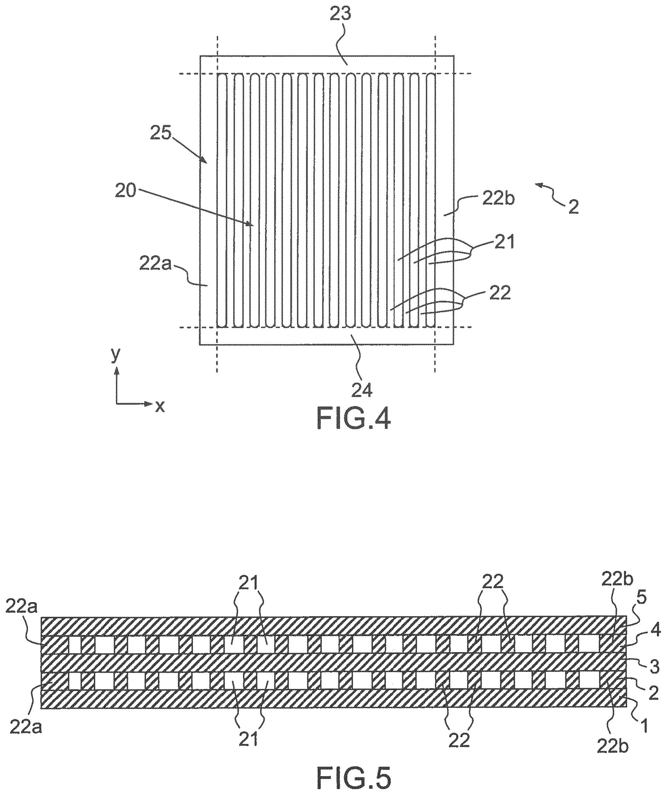

Sur les figures 3 et 4, nous avons représenté schématiquement en perspective et respectivement en vue de dessus, une couche piézoélectrique 2 de l'exemple d'hydrophone représenté sur la figure 1. Avantageusement, mais non nécessairement, les couches 2 et 4 sont identiques.

Cette couche 2 est une plaque comprenant une zone centrale 20, appelée zone centrale perforée, comprenant un ensemble de perforations en forme de rainures 21 s'étendant longitudinalement selon une direction dite longitudinale y perpendiculaire à la direction d'empilement z. Par rainures, on entend des évidements de forme allongée. Les rainures sont sensiblement parallèles entre elles. La zone centrale rainurée 20 est délimitée par deux rainures. Elle est délimitée par les traits pointillés sur la figure 4. Chaque rainure 21 est délimitée, selon la direction x, par des barreaux 22 de matériau piézoélectrique s'étendant longitudinalement selon la direction y. Les barreaux 22 s'étendent sur toute l'épaisseur de la plaque 2 de matériau piézoélectrique. Ils ferment de façon étanche les rainures selon la direction x sur toute l'épaisseur de la plaque. Chaque rainure 21 est délimitée, à ses deux extrémités longitudinales par des talons 23, 24 s'étendant continument le long de la totalité de la zone centrale 20 selon la direction x. Les talons 23, 24 s'étendent continument sur toute l'épaisseur de la plaque 2 de façon à fermer de façon étanche les rainures selon la direction y sur toute l'épaisseur de la plaque 2.

Les couches rigides 1, 3 contiguës à la couche 2 s'étendent sur toute la surface de la zone centrale 20. Sur la réalisation des figures, ces couches rigides 1, 3 s'étendent continument sur toute la surface de la zone centrale 20.

Les rainures 21 traversent la couche 2 selon la direction z. Autrement dit, les rainures 21 débouchent sur les deux couches rigides 1 et 3.

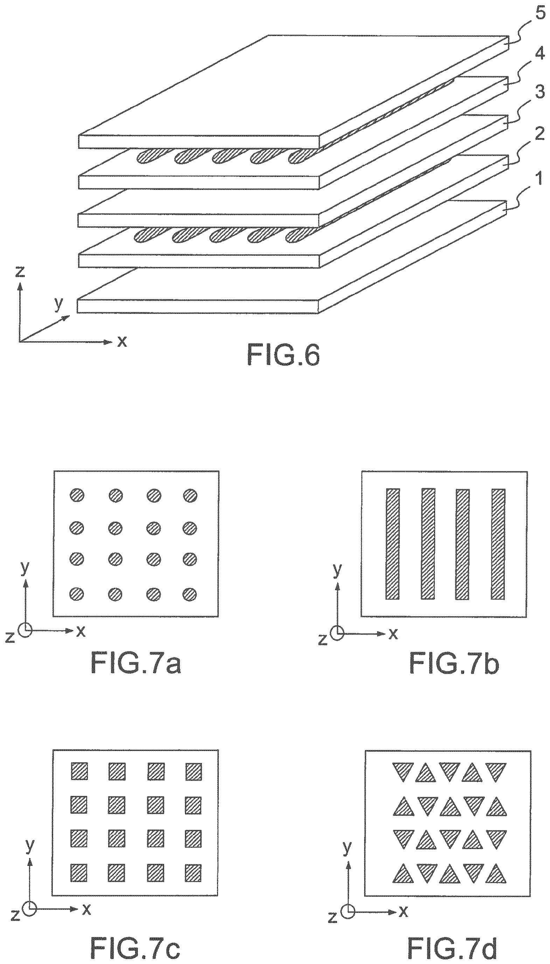

Ainsi, dans l'empilement, comme visible sur la figure 5, chaque rainure 21 forme une perforation fermée de façon étanche par des éléments de fermeture comprenant des portions des deux couches rigides 1, 3, c'est-à- dire les deux couches rigides contiguës, c'est-à-dire collées, à la couche piézoélectrique 2. La figure 6 représente en perspective éclatée l'hydrophone de la figure 1.

Les éléments de fermeture comprennent également les deux barreaux 22 délimitant chaque rainure 21 et les deux talons 23, 24. Chaque rainure 21 est remplie au moins partiellement d'un fluide ou d'un matériau de remplissage solide dont la raideur est nettement inférieure à celle du matériau piézoélectrique. Le fluide de remplissage est par exemple de l'air. Les perforations débouchent sur chacune des couches rigides contiguës à la couche 2, de préférence au moins sur l'essentiel de la longueur des rainures. Autrement dit, lors du collage des couches contiguës, de la colle peut pénétrer dans les rainures et les remplit partiellement. La largeur des rainures, selon la direction x et la fluidité de la colle sont avantageusement choisies de façon que la colle ne pénètre pas ou pénètre de façon marginale dans les rainures. Chaque perforation s'étend avantageusement au moins sur l'essentiel de la longueur de la rainure dans laquelle il est inclus. La largeur des rainures et la fluidité de la colle sont choisies de façon que les perforations débouchent sur chacune des couches rigides contiguës à la couche 2 sur toute sa longueur ou au moins sur l'essentiel de sa longueur. Cela veut dire que la colle ne ferme pas les perforations et ne les sépare pas des couches rigides adjacentes.

Les perforations ont pour fonction de réaliser un découplage latéral dans la direction perpendiculaire x, permettant ainsi de faire travailler le matériau piézoélectrique dans un mode plus favorable que dans un capteur multicouche à plaques homogènes et d'améliorer la sensibilité du capteur par rapport au capteur multicouche à plaques homogènes.

Sur la réalisation des figures 3 et 4, la plaque 2 de matériau piézoélectrique est monobloc. Autrement dit, la plaque 2 est formée d'une seule pièce en matériau piézoélectrique. La plaque 2 comprend une zone centrale rainurée 20 et une zone périphérique 25 fermant les rainures de façon étanche sur toute l'épaisseur de la plaque. Ce mode de réalisation présente l'avantage de permettre de réaliser l'empilement par simple empilement de plaques à moindre coûts tout en assurant l'étanchéité des perforations remplis d'air.

Avantageusement, la zone périphérique 25 est monolithique. Elle forme un cadre en matériau piézoélectrique entourant complètement la zone centrale rainurée 20. Le cadre 25 monolithique est formé des deux talons 23, 24 et des barreaux 22a, 22b entourant la zone centrale rainurée

Dans ce mode de réalisation, la zone périphérique fonctionne en mode d'épaisseur. Le cadre présente l'avantage de garantir une bonne tenue en pression. Ce mode de réalisation, dans lequel le cadre est réalisé en matériau piézoélectrique, présente l'avantage de maximiser la surface active de la couche piézoélectrique. Le surcoût de ce type de solution par rapport au capteur multicouche à plaques homogènes est peu important puisqu'il est uniquement lié à la réalisation des rainures dans les plaques monolithiques utilisées dans le capteur multicouche à plaques homogènes.

Les rainures 21 sont par exemple réalisées par usinage d'une plaque homogène. La plaque peut en variante être obtenue par un moulage permettant directement d'obtenir une plaque rainurée.

En variante, la couche 2 de matériau piézoélectrique comprend un empilement élémentaire de plusieurs plaques monobloc, telles que décrites précédemment, réalisé selon la direction d'empilement z. Les plaques sont empilées de façon que les rainures des plaques soient superposées selon la direction d'empilement de façon à former les perforations. Chaque canal de la couche piézoélectrique est alors formé dans un empilement de rainures réalisé dans les plaques empilées. Les plaques formant une couche piézoélectrique comprennent le même nombre de rainures présentant les mêmes dimensions et sont positionnées de façon que les rainures occupent les mêmes positions dans le plan x, y. De cette façon, les rainures forment des rainures épaisses s'étendant sur toute l'épaisseur de la couche et débouchant de part et d'autre de la couche piézoélectrique.

En variante, l'hydrophone comprend au moins une couche piézoélectrique qui n'est pas monobloc. Autrement dit, les barreaux délimitant les perforations ne forment pas une pièce monobloc mais constituent un assemblage de pièces. Cette couche comprend des perforations séparées par des barreaux en matériau piézoélectrique indépendants. La couche comprend des éléments de fermeture des perforations à leurs extrémités. Les perforations sont par exemple fermées à leurs extrémités par des éléments indépendants de remplissage insérés entre deux barreaux successifs de façon à boucher une extrémité de la perforation, ou bien elles sont fermées par deux pièces de remplissage formant chacune un peigne comprenant des pattes insérées entre deux barreaux successifs. Les éléments de fermeture sont par exemple réalisés en matériau piézoélectrique ou bien en dans un matériau non piézoélectrique comme un polymère.

Avantageusement, au moins une couche de matériau piézoélectrique comprend une zone périphérique formant un cadre monolithique entourant complètement la zone centrale comprenant les perforations.

Dans ce cas où au moins une couche piézoélectrique comprend une zone périphérique formant un cadre monolithique entourant complètement la zone centrale comprenant les perforations, la raideur et l'épaisseur des électrodes sont choisies de façon à être suffisamment rigides par rapport à l'épaisseur et à la raideur du matériau piézoélectrique pour assurer un fonctionnement du matériau piézoélectrique en mode bloqué dans la zone homogène. Cela signifie que les déformation latérales sont annulées ou quasiment annulées dans cette zone. Les couches rigides bloquent la déformation latérale.

De manière générale, les couches rigides permettent de bloquer la déformation latérale du matériau piézoélectrique dans la direction longitudinale y dans la zone centrale, de minimiser la déformation de flexion au droit des rainures, de maximiser le transfert des efforts et d'assurer l'amplification de la contrainte dans les barreaux.

Avantageusement, comme représenté sur la figure 1, chaque couche rigide 1, 3 et 5 s'étend sur la totalité de la surface de chaque couche 2 de matériau piézoélectrique accolée ou contigüe à la couche rigide 1, 3, 5. Cela permet d'améliorer les performances de l'hydrophone en tirant profit de la totalité de la surface active de chaque couche piézoélectrique lors de la mesure de la pression acoustique exercée sur les faces de l'hydrophone.

En variante, au moins une couche rigide s'étend sur une partie de la surface d'au moins une couche piézoélectrique contigüe. L'important étant que les couches rigides s'étendent sur la totalité de la surface de la zone centrale, comprenant les perforations, de chaque couche piézoélectrique adjacente. Cela permet d'assurer la fermeture étanche des perforations lorsqu'elles sont remplies de fluide.

Avantageusement, chaque couche rigide est une couche monobloc.

Les couches piézoélectriques peuvent être réalisées dans des matériaux piézoélectriques homogènes ou composites. Il peut s'agir de matériau piézoélectrique à simple orthotropie pour lequel les propriétés élastiques et piézoélectriques sont identiques suivant les axes x et y, tels que le PVDF polarisé sous contrainte. On peut aussi mettre en œuvre un matériau à double orthotropie pour lequel les propriétés élastiques et piézoélectriques sont différentes suivant les axes x et y, tels que le PVDF poreux, les copolymères tels que le P(VDF-TrFE), les composites 1-3, les céramiques PZT. Avec les matériaux tels que le PVDF poreux, les copolymères, les composites 1-3, les gains de sensibilité et de facteur de mérite, même moins spectaculaires, conduisent à des niveaux de sensibilité et de bruit électrique encore plus performants. Cependant ce surcroît de performance est obtenu au prix d'une augmentation du coût d'approvisionnement et dans certains cas d'une diminution de la plage d'immersion, par exemple dans le cas du PVDF poreux.

La diminution du bruit électrique du capteur est maximisée avec les matériaux présentant une simple orthotropie et un coefficient de Poisson élevé, comme les PVDF polarisés sous contrainte. Dans le cas de matériaux à simple orthotropie, les perforations doivent s'étendre longitudinalement selon une direction y perpendiculaire à la direction d'étirage du matériau à simple orthotropie. Autrement dit, la direction d'étirage du matériau est la direction x. Dans ce cas le découplage latéral est total selon les directions x et y, le matériau piézoélectrique travaille virtuellement en mode de déformation 33, c'est-à-dire en mode longitudinal selon l'axe d'empilement z. Dans ce type de capteur, on constate que dans la partie centrale de la zone rainurée, la contrainte latérale est quasiment nulle.

Avantageusement, la ou les couches piézoélectriques est réalisée dans un matériau possédant un module d'Young supérieur ou égal à 10 GPa et un coefficient de poisson supérieur ou égal à 0,35. Un matériau remplissant ces conditions apporte de la rigidité aux couches piézoélectriques et permet d'améliorer encore la sensibilité de l'hydrophone par rapport à l'art antérieur. Parmi les matériaux rigides on peut notamment utiliser du PZT, du co-polymère ou du PVDF.

Avantageusement, le rapport de forme des barreaux réalisés en matériau piézoélectrique dans la zone centrale est défini par l'épaisseur de la couche piézoélectrique, c'est-à-dire l'épaisseur des barreaux, divisée par la largeur lb des barreaux compris dans la zone centrale. Avantageusement, le rapport de forme est au moins égal à 0,25. Cela permet d'assurer un état de contrainte latérale nulle dans les barreaux. Ce rapport de forme peut être limité par le procédé de réalisation des rainures.

Le gain de sensibilité est d'autant plus grand que la proportion de la surface occupée par les perforations sur la surface de la couche de matériau diélectrique perpendiculairement à la direction d'empilement est élevée. Cependant l'exigence de tenue en pression nécessite une bande homogène minimale. Avantageusement, la proportion de la surface occupée par les perforations sur la surface totale de la couche de matériau diélectrique perpendiculairement à la direction d'empilement dépend de l'utilisation de l'hydrophone. Plus on augmente la surface occupée par les perforations, plus on augmente la sensibilité Sh et plus la capacité Ch diminue.

Avec des couches de matériaux PVDF étiré sous contrainte, la demanderesse a pu constater que, l'augmentation de la sensibilité par rapport à un hydrophone multicouche à plaques homogènes présentant le même nombre de couches réalisées dans les mêmes matériaux et présentant les mêmes dimensions, l'augmentation de sensibilité atteint jusqu'à +10 dB, la réduction de la capacité Ch reste inférieure à 3 dB, pour une augmentation nette du facteur de mérite jusqu'à +7 dB (soit une réduction du bruit électrique du capteur de -7 dB à volume constant).

Les figures 7a à 7d représentent des variantes de la couche piézoélectrique 2 dans lesquelles les perforations ont des formes variées. Sur la figure 7a, les perforations ont une section circulaire, sur la figure 7b, les perforations on une section semblable à celles des figures 1 à 6, sur la figure 7c, les perforations ont une section carrée et sur la figure 7d, les perforations ont une section triangulaire. Comme précédemment, les perforations des figures 7a à 7d traversent de part en part la couche piézoélectrique 2. Ils s'étendent selon la direction d'empilement z. les perforations forment des inclusions remplis de matériau de remplissage. Dans les différentes variantes, la couche piézoélectrique 2 forme un composite de connectivité 3-1. Plus précisément, le matériau piézoélectrique possède une connectivité 3, il est continu suivant les trois directions x, y et z. Le matériau de remplissage possède une connectivité 1, il n'est continu que suivant la direction d'empilement z.

On peut distinguer les perforations de la figures 7b qui s'étendent principalement selon la direction y et les perforations des figures 7a, 7c et 7d qui s'étendent de la même façon dans les directions x et y. Les perforations de faible rapport de forme longueur/largeur (figures 7a, 7c et 7d) sont bien adaptées à un matériau piézoélectrique présentant une isotropie transverse (dans les directions x et y). Les perforations de rapport de forme longueur/largeur élevé (figure 7b) sont bien adaptées à un matériau piézoélectrique sans isotropie transverse tel qu'un matériau étiré. La plus grande dimension des perforations est alors avantageusement perpendiculaire à la direction d'étirage du matériau piézoélectrique.

Sur les figures 7a à 7d, les perforations sont disposées de façon régulière suivant les directions x et y. Une disposition régulière apporte une plus grande homogénéité des contraintes dans le matériau piézoélectrique et améliore ainsi sa tenue en pression. Il est également possible de la disposer de façon irrégulière ou aléatoire. De plus, les perforations représentées sont toutes identiques dans une même variante. Alternativement, il est possible de réaliser dans une même couche 2, des perforations de formes différentes.

L'invention a également pour objet une antenne comprenant une pluralité d'hydrophones selon l'invention.

L'invention a encore pour objet un procédé de réalisation d'un hydrophone selon l'invention, dans lequel les perforations 21 sont réalisées par découpe d'un matériau piézoélectrique monobloc. La découpe est par exemple réalisée par usinage à l'aide d'un outil de coupe ou par usinage laser. Tout autre procédé d'enlèvement de matière adapté à un matériau piézoélectrique peut être mis en œuvre. La découpe permet de réaliser des motifs différents sur une même plaque. Par exemple il pourrait être intéressant d'augmenter la taille des perforations au centre par rapport aux bords de la plaque.

La polarisation du matériau piézoélectrique est généralement orientée parallèlement à la direction z d'empilement des couches et donc parallèlement à la direction des perforations 21. Avantageusement, le matériau piézoélectrique est polarisé avant réalisation des perforations par découpe. La polarisation du matériau piézoélectrique est par exemple réalisée lors de sa mise en forme par étirement. Le matériau piézoélectrique passe entre deux rouleaux réalisant l'étirement. Une forte tension électrique est appliquée entre les rouleaux ou éventuellement entre les rouleaux et une couche conductrice présente à l'intérieur d'un empilement élémentaire formant la couche piézoélectrique. La tension électrique appliquée génère un champ électrique tendant à polariser le matériau piézoélectrique. Il est également possible de polariser le matériau piézoélectrique indépendamment de son étirement.

Parmi les procédés de découpe possibles pour un matériau piézoélectrique, on privilégiera un procédé générant une faible élévation de température pour éviter une dépolarisation partielle du matériau au niveau des borde de découpe.

**Revendications**

1. Hydrophone configuré pour fonctionner en mode traction compression comprenant un empilement (10) de couches (1, 2, 3, 4, 5) collées entre elles, l'empilement étant réalisé selon une direction d'empilement (z), les couches (1, 2, 3, 4, 5) comprenant au moins une couche piézoélectrique (2, 4) et une pluralité de couches dites rigides (1, 3, 5) dont au moins deux sont des couches d'électrodes, dans lequel les couches rigides (1, 3, 5) présentent une raideur perpendiculairement à la direction d'empilement (z), supérieure à une raideur de la couche piézoélectrique perpendiculairement à la direction d'empilement (z), au moins une couche piézoélectrique (2, 4) comprend une zone centrale (20), **caractérisée en ce que** la zone centrale (20) comprend un ensemble de perforations (21) traversant la couche piézoélectrique (2, 4) uniquement selon la direction d'empilement (z), chaque perforation (21) étant fermée de façon étanche par des éléments de fermeture comprenant des portions de deux desdites couches rigides (1, 3, 5), lesdites deux couches rigides (1, 3) s'étendant sur la totalité de la surface de la zone centrale (20), et dans lequel les perforations (21) sont remplies d'un matériau de remplissage formant avec un matériau piézoélectrique de la couche (2, 4) un composite de connectivité 3-1.

2. Hydrophone selon la revendication 1, dans lequel un rapport entre la raideur d'une couche rigide et la raideur d'une couche piézoélectrique adjacente supérieur ou égal à 2,5

3. Hydrophone selon l'une des revendications précédentes, dans lequel le matériau de remplissage est un fluide dont le module de compressibilité isotrope est inférieur au quart du module de compressibilité isotrope du matériau piézoélectrique.

4. Hydrophone selon l'une des revendications 1 ou 2, dans lequel le matériau de remplissage est un solide dont le module d'Young est inférieur au quart du module d'Young du matériau piézoélectrique défini perpendiculairement au plan de la couche piézoélectrique (2, 4).

5. Hydrophone selon l'une quelconque des revendications précédentes, dans lequel la couche piézoélectrique (2, 4) comprend la zone centrale (20) et un cadre monolithique (25) entourant complètement la zone centrale (20), le cadre monolithique (25) étant réalisé en matériau piézoélectrique.

6. Hydrophone selon l'une quelconque des revendications précédentes, dans lequel au moins une couche piézoélectrique (2, 4) comprend une unique plaque monobloc de matériau piézoélectrique.

7. Hydrophone selon l'une quelconque des revendications 1 à 5, dans lequel au moins une couche piézoélectrique (2, 4) comprend un empilement élémentaire réalisé selon la direction d'empilement (z) d'une pluralité de plaques monoblocs de matériau piézoélectrique, chaque plaque monobloc comprenant une zone centrale (20) comprenant une pluralité de perforations, les plaques étant empilées de façon que les perforations desdites plaques soient superposées dans la direction d'empilement (z).

8. Hydrophone selon l'une quelconque des revendications précédentes, dans lequel chaque couche rigide (1, 3, 5) s'étend sur la totalité de la surface de chaque couche piézoélectrique (2, 4) qui est contiguë à ladite couche rigide (1, 3, 5) dans l'empilement (10).

9. Hydrophone selon l'une quelconque des revendications précédentes, dans lequel au moins une couche piézoélectrique (2, 4) comprenant une zone centrale (20) comprenant un ensemble de perforations (21) est réalisée dans un matériau piézoélectrique simple orthotrope étiré selon la direction longitudinale, tel que le PVDF, ou dans un matériau piézoélectrique double orthotrope tel qu'un copolymère.

10. Hydrophone selon l'une quelconque des revendications précédentes, dans lequel au moins une couche piézoélectrique comprenant une zone centrale (20) comprenant un ensemble de perforations (21) est réalisée dans un matériau possédant un module d'Young supérieur ou égal à 10 GPa et un coefficient de poisson supérieur ou égal à 0,35 et est notamment réalisée en PZT.

11. Hydrophone selon l'une quelconque des revendications 1 à 9, dans lequel au moins une couche piézoélectrique comprenant une zone centrale (20) comprenant un ensemble de perforations (21) est réalisée à partir d'un matériau piézo-composite de type 1-3.

12. Hydrophone selon l'une quelconque des revendications précédentes, dans lequel les perforations (21) sont séparés deux à deux par des barreaux (22) de matériau piézoélectrique et dans lequel au moins une couche piézoélectrique comprenant une zone centrale (20) comprenant un ensemble de perforations (21) est dimensionnée de façon qu'un rapport de forme des barreaux (22) défini par le rapport entre l'épaisseur de la couche piézoélectrique et la largeur des barreaux compris dans la zone centrale (20) selon une direction perpendiculaire aux directions longitudinale (y) et d'empilement (z) de ladite couche est au moins égal à 0,25.

13. Hydrophone selon l'une quelconque des revendications précédentes, dans lequel la couche piézoélectrique (2, 4) est formée dans un matériau présentant une isotropie transverse perpendiculairement à la direction d'empilement (z) et dans lequel les perforations (21) s'étendent de la même façon dans deux directions (x, y) perpendiculaires à la direction d'empilement (z).

14. Hydrophone selon l'une quelconque des revendications 1 à 12, dans lequel la couche piézoélectrique (2, 4) est formée dans un matériau présentant une anisotropie transverse perpendiculairement à la direction d'empilement (z) et dans lequel les perforations (21) s'étendent principalement dans une direction (y) perpendiculaire à la direction d'empilement (z).

15. Hydrophone selon l'une quelconque des revendications précédentes, dans lequel les perforations (21) sont disposées de façon régulière dans deux directions (x, y) perpendiculaires à la direction d'empilement (z).

16. Antenne de réception comprenant une pluralité d'hydrophones selon l'une quelconque des revendications précédentes.

17. Procédé de réalisation d'un hydrophone selon l'une quelconque des revendications 1 à 15, dans lequel les perforations (21) sont réalisées par découpe d'un matériau piézoélectrique monobloc.

18. Procédé selon la revendication 17, dans lequel le matériau piézoélectrique est polarisé avant réalisation des perforations (21) par découpe.


**Patentansprüche**

1. Hydrophon, welches konfiguriert ist, um im Zug-Druck-Modus zu arbeiten, umfassend einen Stapel (10) von miteinander verklebten Schichten (1, 2, 3, 4, 5), wobei der Stapel entsprechend einer Stapelrichtung (z) hergestellt ist, wobei die Schichten (1, 2, 3, 4, 5) mindestens eine piezoelektrische Schicht (2, 4) und eine Vielzahl von sogenannten starren Schichten (1, 3, 5) umfasst, wovon mindestens zwei Elektrodenschichten sind, wobei die starren Schichten (1, 3, 5) eine Steifheit rechtwinklig zur Stapelrichtung (z) aufweisen, welche eine Steifheit der piezoelektrischen Schicht rechtwinklig zur Stapelrichtung (z) überschreitet, wobei mindestens eine piezoelektrische Schicht (2, 4) einen mittleren Bereich (20) umfasst, **dadurch gekennzeichnet, dass** der mittlere Bereich (20) eine Gruppe von Perforationen (21) umfasst, welche die piezoelektrische Schicht (2, 4) ausschließlich in der Stapelrichtung (z) durchquert, wobei jede Perforation (21) dicht durch Verschlusselemente verschlossen ist, welche Abschnitte zweier sogenannter starrer Schichten (1, 3, 5) umfassen, wobei die beiden starren Schichten (1, 3) sich über die gesamte Fläche des mittleren Bereichs (20) erstrecken, und wobei die Perforationen (21) mit einem Füllmaterial gefüllt sind, welches mit einem piezoelektrischen Material der Schicht (2, 4) einen Konnektivitäts-Verbundstoff 3-1 bildet.

2. Hydrophon nach Anspruch 1, wobei ein Verhältnis zwischen der Steifheit einer starren Schicht und der Steifheit einer angrenzenden piezoelektrischen Schicht größer oder gleich 2,5 beträgt.

3. Hydrophon nach einem der vorhergehenden Ansprüche, wobei das Füllermaterial ein Fluid ist, dessen isotropes Kompressionsmodul kleiner als ein Viertel des isotropen Kompressionsmoduls des piezoelektrischen Materials ist.

4. Hydrophon nach einem der Ansprüche 1 oder 2, wobei das Füllmaterial ein Feststoff ist, dessen Young'sches Modul kleiner als ein Viertel des Young'schen Moduls des piezoelektrischen Materials ist, welches rechtwinklig zur Ebene der piezoelektrischen Schicht (2, 4) definiert ist.

5. Hydrophon nach einem der vorhergehenden Ansprüche, wobei die piezoelektrische Schicht (2, 4) einen mittleren Bereich (20) und einen monolithischen Rahmen (25) umfasst, welcher den mittleren Bereich (20) vollständig umgibt, wobei der monolithische Rahmen (25) aus piezoelektrischem Material hergestellt ist.

6. Hydrophon nach einem der vorhergehenden Ansprüche, wobei mindestens eine piezoelektrische Schicht (2, 4) eine einzige einstückige Platte aus piezoelektrischem Material umfasst.

7. Hydrophon nach einem der Ansprüche 1 bis 5, wobei mindestens eine piezoelektrische Schicht (2, 4) einen Elementarstapel umfasst, welcher in der Stapelrichtung (z) hergestellt ist, aus einer Vielzahl von einstückigen Platten aus piezoelektrischem Material, wobei jede einstückige Platte einen mittleren Bereich (20) umfasst, welcher eine Vielzahl von Perforationen umfasst, wobei die Platten so gestapelt sind, dass die Perforationen der Platten einander in der Stapelrichtung (z) überlagern.

8. Hydrophon nach einem der vorhergehenden Ansprüche, wobei jede starre Schicht (1, 3, 5) sich über die gesamte Fläche einer jeden piezoelektrischen Schicht (2, 4) erstreckt, welche an die starre Schicht (1, 3, 5) in dem Stapel (10) angrenzt.

9. Hydrophon nach einem der vorhergehenden Ansprüche, wobei mindestens eine piezoelektrische Schicht (2, 4), welche einen mittleren Bereich (20) umfasst, welcher eine Gruppe von Perforationen (21) umfasst, aus einem einfach orthotropen piezoelektrischen Material hergestellt ist, welches entlang der Längsrichtung gestreckt ist, wie beispielsweise PVDF, oder aus einem doppelt orthotrhropen piezoelektrischen Material wie beispielsweise einem Copolymer.

10. Hydrophon nach einem der vorhergehenden Ansprüche, wobei mindestens eine piezoelektrische Schicht, welche einen mittleren Bereich (20) umfasst, welcher eine Gruppe von Perforationen (21) umfasst, aus einem Material hergestellt ist, welches ein Young'sches Modul größer oder gleich 10 GPa und eine Poissonzahl größer oder gleich 0,35 aufweist und insbesondere aus PZT hergestellt ist.

11. Hydrophon nach einem der Ansprüche 1 bis 9, wobei mindestens eine piezoelektrische Schicht, welche einen mittleren Bereich (20) umfasst, welcher eine Gruppe von Perforationen (21) umfasst, anhand eines Piezo-Verbundstoffs vom Typ 1-3 hergestellt ist.

12. Hydrophon nach einem der vorhergehenden Ansprüche, wobei die Perforationen (21) paarweise durch Sprossen (22) aus piezoelektrischem Material getrennt sind, und wobei mindestens eine piezoelektrische Schicht, welche einen mittleren Bereich (20) umfasst, welcher eine Gruppe von Perforationen (21) umfasst, so dimensioniert ist, dass ein Verhältnis zwischen der Form der Sprossen (22), definiert durch das Verhältnis zwischen der Dicke der elektroelektrischen Schicht und der Breite der Sprossen, welche in dem mittleren Bereich (20) entlang einer Richtung rechtwinklig zu der Längsrichtung (y) und der Stapelrichtung (z) der Schicht definiert ist, mindestens gleich 0,25 beträgt.

13. Hydrophon nach einem der vorhergehenden Ansprüche, wobei die piezoelektrische Schicht (2, 4) aus einem Material gebildet ist, welches eine transversale Isotropie rechtwinklig zur Stapelrichtung (z) aufweist und wobei die Perforationen (21) sich in gleicher Weise in zwei zu der Stapelrichtung (z) rechtwinklige Richtungen (x, y) erstrecken.

14. Hydrophon nach einem der Ansprüche 1 bis 12, wobei die piezoelektrische Schicht (2, 4) aus einem Material gebildet ist, welches eine transversale Anisotropie rechtwinklig zur Stapelrichtung (z) aufweist und wobei die Perforationen (21) sich hauptsächlich in eine zu der Stapelrichtung (z) rechtwinklige Richtung (y) erstrecken.

15. Hydrophon nach einem der vorhergehenden Ansprüche, wobei die Perforationen (21) regelmäßig in zwei zu der Stapelrichtung (z) rechtwinkligen Richtungen (x, y) angeordnet sind.

16. Empfangsantenne, umfassend eine Vielzahl von Hydrophonen nach einem der vorhergehenden Ansprüche.

17. Verfahren zur Herstellung eines Hydrophons nach einem der Ansprüche 1 bis 15, wobei die Perforationen (21) durch Ausschneiden eines einstückigen piezoelektrischen Materials hergestellt werden.

18. Verfahren nach Anspruch 17, wobei das piezoelektrische Material vor der Herstellung der Perforationen (21) durch Ausschneiden polarisiert ist.

**Claims**

1. A hydrophone configured to operate in push-pull mode comprising a stack (10) of layers (1, 2, 3, 4, 5) that are bonded to one another, the stack being produced along a direction of stacking (z), the layers (1, 2, 3, 4, 5) comprising at least one piezoelectric layer (2, 4) and a plurality of layers referred to as rigid layers (1, 3, 5), at least two of which are electrode layers, in which the rigid layers (1, 3, 5) exhibit a stiffness perpendicularly to the direction of stacking (z), which is higher than a stiffness of the piezoelectric layer perpendicularly to the direction of stacking (z), at least one piezoelectric layer (2, 4) comprises a central zone (20) **characterized in that** the central zone (20) comprises a set of perforations (21) that pass through the piezoelectric layer (2, 4) solely along the direction of stacking (z), each perforation (21) being closed tight by closure elements comprising portions of two of said rigid layers (1, 3, 5), said two rigid layers (1, 3) extending over the entirety of the surface of the central zone (20), and in which the perforations (21) are filled with a filler material forming, with a piezoelectric material of the layer (2, 4), a connectivity composite 3-1.

2. The hydrophone according to claim 1, in which a ratio of the stiffness of a rigid layer to the stiffness of an adjacent piezoelectric layer is higher than or equal to 2.5.

3. The hydrophone according to any one of the preceding claims, in which the filler material is a fluid the isotropic bulk modulus of which is less than a quarter of the isotropic bulk modulus of the piezoelectric material.

4. The hydrophone according to any one of claims 1 or 2, in which the filler material is a solid the Young's modulus of which is less than a quarter of the Young's modulus of the piezoelectric material defined perpendicularly to the plane of the piezoelectric layer (2, 4).

5. The hydrophone according to any one of the preceding claims, in which the piezoelectric layer (2, 4) comprises the central zone (20) and a monolithic frame (25) that completely surrounds the central zone (20), the monolithic frame (25) being made of a piezoelectric material.

6. The hydrophone according to any one of the preceding claims, in which at least one piezoelectric layer (2, 4) comprises a single unitary plate of piezoelectric material.

7. The hydrophone according to any one of claims 1 to 5, in which at least one piezoelectric layer (2, 4) comprises an elementary stack produced along the direction of stacking (z) of a plurality of unitary plates of piezoelectric material, each unitary plate comprising a central zone (20) that comprises a plurality of perforations, the plates being stacked so that the perforations of said plates are superposed in the direction of stacking (z).

8. The hydrophone according to any one of the preceding claims, in which each rigid layer (1, 3, 5) extends over the entirety of the surface of each piezoelectric layer (2, 4) that is contiguous with said rigid layer (1, 3, 5) in the stack (10).

9. The hydrophone according to any one of the preceding claims, in which at least one piezoelectric layer (2, 4) comprising a central zone (20) that comprises a set of perforations (21) is made in a simple orthotropic piezoelectric material drawn out along the longitudinal direction, such as PVDF or in a double orthotropic piezoelectric material such as a copolymer.

10. The hydrophone according to any one of the preceding claims, in which at least one piezoelectric layer comprising a central zone (20) that comprises a set of perforations (21) is made in a material having a Young's modulus that is higher than or equal to 10 GPa and a Poisson's ratio that is higher than or equal to 0.35, and is made in particular of PZT.

11. The hydrophone according to any one of claims 1 to 9, in which at least one piezoelectric layer comprising a central zone (20) that comprises a set of perforations (21) is made from a 1-3 piezocomposite material.

12. The hydrophone according to any one of the preceding claims, in which the perforations (21) are separated pairwise by bars (22) of piezoelectric material and in which at least one piezoelectric layer comprising a central zone (20) that comprises a set of perforations (21) is dimensioned so that an aspect ratio of the bars (22), defined by the ratio of the thickness of the piezoelectric layer to the width of the bars comprised in the central zone (20) along a direction that is perpendicular to the longitudinal direction (y) and to the direction of stacking (z) of said layer, is at least equal to 0.25.

13. The hydrophone according to any one of the preceding claims, in which the piezoelectric layer (2, 4) is formed in a material exhibiting transverse isotropy perpendicularly to the direction of stacking (z) and in which the perforations (21) extend similarly in two directions (x, y) that are perpendicular to the direction of stacking (z).

14. The hydrophone according to any one of claims 1 to 12, in which the piezoelectric layer (2, 4) is formed in a material exhibiting transverse anisotropy perpendicularly to the direction of stacking (z) and in which the perforations (21) extend mainly in a direction (y) that is perpendicular to the direction of stacking (z).

15. The hydrophone according to any one of the preceding claims, in which the perforations (21) are positioned regularly in two directions (x, y) that are perpendicular to the direction of stacking (z).

16. A receiving antenna comprising a plurality of hydrophones according to any one of the preceding claims.

17. A method for producing a hydrophone according to any one of claims 1 to 15, in which the perforations (21) are produced by cutting a unitary piezoelectric material.

18. The method according to claim 17, in which the piezoelectric material is polarized before production of the perforations (21) by cutting.

FIG.1

FIG.2

**FIG.3**

FIG.4

FIG.5

FIG.6

FIG.7a

FIG.7b

FIG.7c

FIG.7d

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **R. GENTILMAN et al.** Sonopanel 1-3 piezocomposite hydrophone actuator panels. *OCEANS'95 MTS/IEEE,* 1995, 2032-2037